# EUROPÄISCHE PATENTSCHRIFT

(11) **EP 2 676 874 B1**
(45) Veröffentlichungstag und Bekanntmachung des Hinweises auf die Patenterteilung: **27.04.2016**
(21) Anmeldenummer: 13172744.8
(22) Anmeldetag: 19.06.2013
(51) Int. Cl.: B62K 25/00, B62M 6/90, B62M 6/65, B62K 19/30, G01R 31/36, H01M 10/48

(54) **Einarmstütze für ein Elektrofahrrad**
Single arm support for electric bicycle
Support à branche unicle pour bicyclette électrique

(30) Priorität: 21.06.2012 DE 202012005975 U
(43) Veröffentlichungstag der Anmeldung: 25.12.2013
(73) Patentinhaber: Blümel, Matthias, 85625 Glonn (DE)
(72) Erfinder: Blümel, Matthias, 85625 Glonn (DE)
(74) Vertreter: Horn Kleimann Waitzhofer Patentanwälte PartG mbB

(56) Entgegenhaltungen:
- EP-A1- 2 572 970
- EP-A2- 2 228 293
- EP-A2- 2 357 128
- WO-A1-2009/027683
- WO-A2-2011/081359
- CN-Y- 201 128 466
- DE-A1-102010 032 720
- DE-U1-202011 003 180
- ES-A1- 2 358 714
- JP-A- 2011 025 717
- KR-A- 20120 027 589

## Beschreibung

Die vorliegende Erfindung betrifft eine Einarmstütze für ein Elektrofahrrad.

Elektrofahrräder erfreuen sich zunehmender Beliebtheit. Diese weisen einen Energiespeicher für elektrische Energie sowie einen Elektromotor auf, welcher zum Erzeugen von Antriebskraft mit der Energie aus dem Energiespeicher versorgt wird.

Üblicherweise wird der Energiespeicher auf dem Gepäckträger oder an einer geeigneten Stelle am Fahrradrahmen montiert. Das damit einhergehende Erscheinungsbild des Elektrofahrrads wird oft als wenig ästhetisch empfunden. Außerdem sind für die Montage regelmäßig Zusatzteile erforderlich, wodurch sich die Herstellungskosten und der Herstellungsaufwand erhöhen. Ferner ist der Energiespeicher bei dieser Art der Montage gegenüber Einwirkung von außen, beispielsweise Vandalismus, oft nicht oder nur unzureichend geschützt.

Dokument KR20120027589 offenbart eine Einarmstütze für ein Elektrofahrrad gemäß dem Oberbegriff von Anspruch 1.

Die Aufgabe der vorliegenden Erfindung besteht darin, eine verbesserte Lösung zu schaffen.

Diese Aufgabe wird gelöst durch eine Einarmstütze für ein Elektrofahrrad zur Anbindung eines Vorder- oder Hinterrads des Elektrofahrrads an einen Rahmen desselben gemäß den Merkmalen von Anspruch 1.

Einarmstützen weisen im Unterschied zu Vorderradgabeln oder Hinterraddoppelschwingen einen großen Querschnitt auf, da sie insbesondere große Torsionsmomente aufgrund ihres unsymmetrischen Aufbaus aufnehmen müssen. Die der vorliegenden Erfindung zugrunde liegende Idee besteht nun darin, diesen großen Querschnitt zur Unterbringung des Energiespeichers zu nutzen. Es wird also vorteilhaft ein bereits vorhandener Raum für die Unterbringung des Energiespeichers genutzt. Damit lässt sich der Energiespeicher platzsparend unterbringen. Außerdem ist der Energiespeicher somit vor einer Einwirkung von außen geschützt untergebracht. Ferner ist der Energiespeicher somit von außen praktisch nicht wahrnehmbar, was ästhetisch vorteilhaft ist.

Gemäß der Erfindung ist der Energiespeicher in Längsrichtung des Rohrs in dieses einführbar. Erfindungsgemäß wird der Energiespeicher von oben in das Rohr eingeführt. Damit ergibt sich eine ergonomisch gute Austauschbarkeit des Energiespeichers. Für das Einführen des Energiespeichers kann dieser oder das Rohr geeignete Führungsmittel aufweisen. Beispielsweise können solche Führungsmittel in Form von Kunststoffringen ausgebildet sein, welche an dem Energiespeicher angebracht sind.

Gemäß der Erfindung ist das Rohr an seinem einen Ende offen zum Einführen und Entnehmen des Energiespeichers ausgebildet. Ein solches Rohr lässt sich einfach herstellen.

Gemäß einer bevorzugten Ausführungsform ist das eine Ende des Rohrs mittels eines Deckels verschließbar. Der Deckel kann Bestandteil des Energiespeichers sein. Der Deckel kann so eingerichtet sein, dass er ohne weiteres Zutun nach Einführen des Energiespeichers in das Rohr das eine (offene) Ende verschließt. Der Energiespeicher kann an seinem Umfang eine oder mehrere Dichtungen aufweisen, so dass ein Eindringen von Staub zwischen diesen und das Rohr verhindert wird.

Gemäß einer weiteren bevorzugten Ausführungsform ist der Deckel und/oder das offene Ende des Rohres der Einarmstütze mit einem geeigneten Sperrmittel, wie zum Beispiel einem Schloss, versehen. Das Sperrmittel kann zweierlei Funktionen erfüllen. Zum einen dient es dem Schutz des Energiespeichers vor Diebstahl, zum andern kann es so ausgeprägt sein, dass es den Energiespeicher in seiner Position zusätzlich fixiert.

Gemäß einer weiteren bevorzugten Ausführungsform weist der Deckel eine Anzeigeeinheit zur Anzeige einer Energiespeicherinformation und/oder zur Anzeige von Information zum aktuellen Fahrbetrieb, wie beispielsweise Fahrgeschwindigkeit und Kilometerstand und/oder ein oder mehrerer Bedienelemente zum Bereitstellen einer Bedieninformation an eine Steuereinrichtung, welche den Energiespeicher und/oder eine von einem Elektromotor zu erzeugende Leistung steuert, auf. Insbesondere kann die Energiespeicherinformation eine Ladezustandsinformation des Energiespeichers sein. Der Deckel, welcher das eine offene Ende des Rohrs verschließt, ist also bevorzugt in dem Energiespeicher integriert. Dadurch ergibt sich der Vorteil, dass ein separates Teil, welches beispielsweise verloren gehen kann bzw. bei einer Montage aufwändig zusätzlich vorgesehen werden muss, vermieden wird. In dem Fall, dass der Deckel die Anzeigeeinheit aufweist, ergibt sich vorteilhaft, dass die Energiespeicherinformation dem Benutzer auch dann zur Verfügung steht, wenn dieser den Energiespeicher von dem Elektrofahrrad beispielsweise zum Laden des Energiespeichers entfernt hat. Der Benutzer kann dann insbesondere die auf der Anzeigeeinheit angezeigte Information, beispielsweise den Ladezustand des Energiespeichers, an einem vom Elektrofahrrad entfernten Ort, also insbesondere dort, wo der Energiespeicher geladen wird, ablesen. Bei dem Bedienelement kann es sich um einen Knopf, Schalter oder dergleichen handeln. Weiterhin kann das Bedienelement als ein Touchelement eines Touchscreens ausgebildet sein. Beispielsweise können auf dem Touchscreen Energiespeicherinformationen und/oder Informationen zum aktuellen Fahrbetrieb angezeigt werden. Außerdem kann die Steuereinrichtung über ein oder mehrere Bedienelemente in Form von Touchelementen auf dem Touchscreen gesteuert werden.

Gemäß einer weiteren bevorzugten Ausführungsform ist das Rohr mit einem Lenkerrohr verbunden. Diese Verbindung kann fest oder beweglich vorgesehen sein. Die bewegliche Verbindung kann beispielsweise durch einen Parallelogrammlenker oder andere Mittel geschaffen werden, um ein Einfedern des Rohrs gegenüber dem Lenkerrohr zu ermöglichen, um so eine Vorder- oder Hinterraddämpfung darzustellen. Das Rohr und das Lenkerrohr können parallel oder von der Parallelen um beispielsweise nicht mehr als 30° abweichend zueinander angeordnet sein.

Gemäß einer weiteren bevorzugten Ausführungsform weist das Rohr einen kreisförmigen oder ovalen Querschnitt auf. Ein solches Rohr ist einfach herzustellen. Außerdem lassen sich in dem so gebildeten Querschnitt übliche Formen von Energiespeichern gut unterbringen.

Gemäß der Erfindung ist das Rohr mit einer Aufnahme verbunden, in welcher ein Elektromotor zum Antreiben des Vorder- oder Hinterrads aufgenommen ist. Wird ein Elektromotor in der Aufnahme montiert, ergibt sich so eine kompakte, gut handhabbare und einfach versendbare (beispielsweise zu Wartungszwecken) Einheit. Die Aufnahme kann beispielsweise mit dem Rohr einstückig gebildet, insbesondere mit diesem durch Verschweißen oder Kleben verbunden sein.

Gemäß einer weiteren bevorzugten Ausführungsform ist das Vorder- oder Hinterrad mit einer Welle des Elektromotors zumindest in einer Drehrichtung drehfest verbindbar. Beispielsweise kann die drehfeste Verbindung in nur einer Drehrichtung mittels eines Freilaufs gewährleistet werden. Alternativ kann das Vorder- oder Hinterrad auch in beide Drehrichtungen (Richtung und Gegenrichtung) drehfest mit der Welle des Elektromotors verbunden sein. Weiterhin kann die Verbindung zwischen Vorder- oder Hinterrad und der Welle des Elektromotors mittels eines Schnellverschlusses vorgesehen sein.

Weiterhin wird ein Elektrofahrrad mit einem Rahmen, einem Vorder- und Hinterrad und der erfindungsgemäßen Einsarmstütze geschaffen. Die Einarmstütze bindet das Vorder- oder Hinterrad an den Rahmen an. Die Einarmstütze ist bevorzugt mit einem Lenkerrohr des Elektrofahrrads verbunden. Weiterhin könnte sowohl das Vorder- als auch das Hinterrad über jeweils eine Einarmstütze mit dem Rahmen verbunden sein.

Ausführungsbeispiele der Erfindung werden nachfolgend anhand der beiliegenden Figuren der Zeichnungen näher erläutert.

Es zeigen dabei:
- Figur 1: in perspektivischer Ansicht eine Einarmstütze gemäß einer Ausführungsform;
- Figur 2: eine Ansicht II aus Figur 1;
- Figur 3: eine Ansicht III aus Figur 1;
- Figur 4: eine Ansicht IV aus Figur 1;
- Figur 5: eine Ansicht V aus Figur 1;
- Figur 6: einen Schnitt VI-VI aus Figur 1;und
- Figur 7: eine Ansicht eines Elektrofahrrads mit der Einarmstütze aus Fig.1.

In den Figuren bezeichnen gleiche Bezugszeichen gleiche oder funktionsgleiche Elemente, soweit nichts anderes angegeben ist.

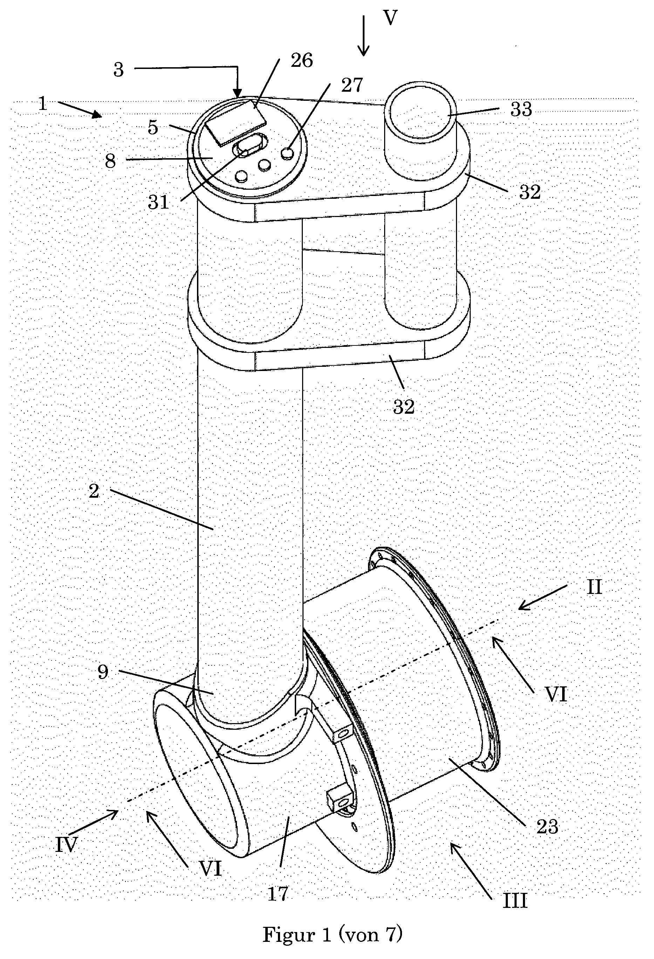

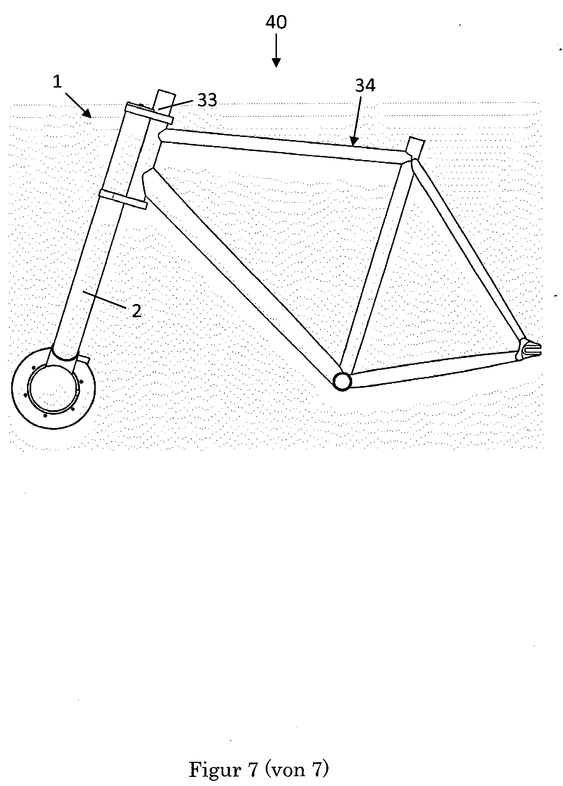

Figur 1 zeigt eine Einarmstütze 1 für ein in Fig.7 teilweise dargestelltes Elektrofahrrad 40. Das Elektrofahrrad 40 umfasst ein nicht dargestelltes Vorder- und Hinterrad sowie einen Rahmen 34. Die Einarmstütze 1 kann das Vorder- oder Hinterrad mit dem Rahmen 34 verbinden. Alternativ ist es auch möglich, zwei Einarmstützen zu verwenden, so dass sowohl das Vorder- als auch das Hinterrad jeweils mittels einer Einarmstütze mit dem Rahmen verbunden sind (nicht gezeigt).

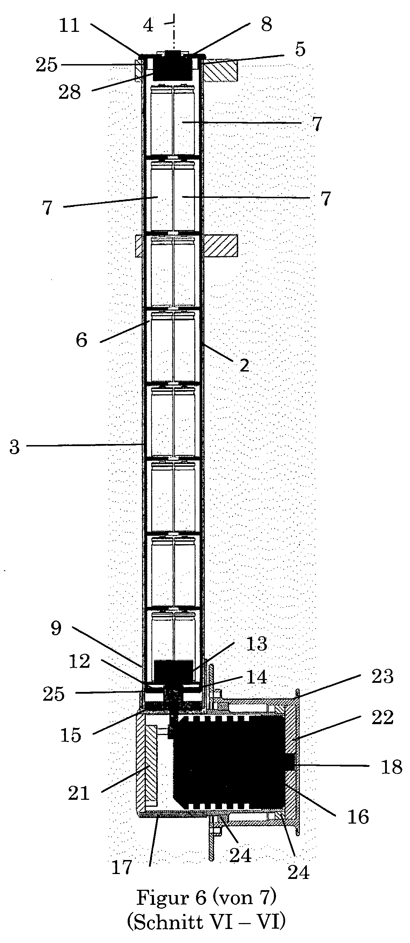

Die Einarmstütze 1 umfasst ein Rohr 2, in welchem ein in Figur 6 dargestellter Energiespeicher 3 aufnehmbar ist. Das Rohr 2 ist gemäß dem Ausführungsbeispiel mit einem runden Querschnitt ausgeführt. Der Energiespeicher 3 ist in Form eines Kreiszylinders ausgestaltet, welcher in Längsrichtung 4 (siehe Figur 6) in das eine offene Ende 5 des Rohrs 2 von oben einschiebbar ist.

Der Energiespeicher 3 kann beispielsweise dergestalt ausgeführt sein, dass er selbst ein Rohr 6 aufweist. In dem Rohr 6 sind eine Vielzahl von Energiespeicherzellen 7 neben- und hintereinander angeordnet und miteinander kontaktiert, so dass beispielsweise mehrere der Energiespeicherzellen 7 miteinander in Reihe geschaltet sind. Das Ende 5 des Rohrs 2 ist mit einem Deckel 8 verschlossen, welcher mit dem Rohr 6 des Energiespeichers 3 fest verbunden ist, beispielsweise durch Einschrauben oder Verkleben mit dem Rohr 6. Der Deckel 8 ist mit einem über das Rohr 6 radial überstehenden Rand 11 gebildet, welcher im in das Rohr 2 eingeschobenen Zustand des Energiespeichers 3 über dieses übersteht. "Radial" bezieht sich vorliegend auf die Längsrichtung 4. An seinem anderen Ende 9 kann das Rohr 6 mittels eines Stopfens 12 verschlossen sein. Der Stopfen 12 kann mit einer Buchse 13 ausgebildet sein, welche beim Einschieben des Energiespeichers 3 in das Rohr 2 automatisch in elektrischen Kontakt mit einem Stecker 14 am Boden 15 des Rohrs 2 tritt. Über diese elektrische Verbindung wird dann ein Elektromotor 16, welcher in einer mit dem Rohr 2 fest verbundenen Aufnahme 17 angeordnet ist, mit Strom versorgt. Das andere Ende 9 des Rohrs 2 ist beispielsweise mit der Aufnahme 17 verschweißt. In der Aufnahme 17, die beispielsweise in Form eines Topfes gebildet ist, kann über den Elektromotor 16 hinaus eine Steuereinrichtung 21 beispielsweise in Form einer Platine angeordnet sein. Auch die Steuereinrichtung 21 wird über die elektrischen Kontakte 13, 14 mit Strom versorgt. Die Steuereinrichtung 21 ist bevorzugt ferner beispielsweise über Kabel mit einer im Deckel 8 des Energiespeichers integrierten Bedien- /Anzeigeeinrichtung und/oder einer Bedien- /Anzeigeeinrichtung (nicht dargestellt) am Lenker des Elektrofahrrads verbunden. Mittels der Bedieneinrichtung (im Deckel 8 oder am Lenker) kann dann beispielsweise die von dem Elektromotor 16 zu erzeugende Leistung durch entsprechende Ansteuerung der Steuereinrichtung 21 vorgegeben werden.

Eine Welle 18 des Elektromotors 16 ist beispielsweise über einen Freilauf 22 mit einer Nabe 23 des im Übrigen nicht näher dargestellten Vorderrads verbunden. Die Nabe 23 kann sich wiederum über Lager 24 an der Aufnahme 17 abstützen. Die Nabe 23 ist somit mittels des Freilaufs 22 in einer Richtung, also in der Antriebsrichtung, drehfest mit dem Elektromotor 16 verbunden.

Um ein Einführen des Energiespeichers 3 in das Rohr 2 zu erleichtern, können an den gegenüberliegenden Enden 5, 9 des Energiespeichers 3, insbesondere des Rohrs 6, Kunststoffringe 25 vorgesehen sein. Außerdem wird durch die Kunststoffringe 25 auch das Herausziehen des Energiespeichers 3 aus dem Rohr 2 erleichtert. Anstelle der Kunststoffringe 25 könnten auch andere Gleitmittel, insbesondere Gleitringe, verwendet werden. Weiterhin sorgen die Kunststoffringe 25 für eine Abdichtung des Rohrs 2, also dessen Innenraums, gegenüber der Umgebung, so dass Staub und Feuchtigkeit daran gehindert wird, in den Spalt zwischen dem Rohr 2 und dem Energiespeicher 3 einzudringen. Anstelle der Kunststoffringe 25 könnten jedoch auch andere Dichtmittel, insbesondere Dichtringe, verwendet werden.

Wird der Energiespeicher 3 nun aus dem Rohr 2 herausgezogen, um diesen an einer von dem Elektrofahrrad beispielsweise entfernten Stelle zu laden, so kann eine in den Deckel 8 integrierte Anzeigeeinrichtung 26 dem Benutzer Aufschluss über einen Ladezustand des Energiespeichers 3 geben. Dazu ist die Anzeigeeinrichtung 26 mit einer Elektronik 28 verbunden, welche in dem Rohr 6 untergebracht ist. Außerdem kann in den Deckel 8 ein Bedienelement 27 integriert sein, welches die Elektronik 28 steuert. Durch Bedienen des Bedienelements 27 kann beispielsweise der Energiespeicher 3 ein- oder ausgeschaltet werden. Im eingeschalteten Zustand kann der Energiespeicher 3 Energie an den Elektromotor 16 abgeben, im ausgeschalteten Zustand dagegen nicht. Außerdem könnte mittels des Bedienelements 27, im eingebauten Zustand des Energiespeichers 3 in dem Rohr 2, die Steuereinrichtung 21 direkt angesteuert werden.

In den Deckel 8 kann außerdem ein Stecker 31 integriert sein, über welchen durch entsprechendes Anschließen eines Ladekabels der Energiespeicher 3 geladen werden kann. Dieses Laden kann im in das Rohr 2 eingeschobenen Zustand des Energiespeichers 3 oder auch, wenn der Energiespeicher 3 aus dem Rohr 2 entnommen worden ist, vorgenommen werden.

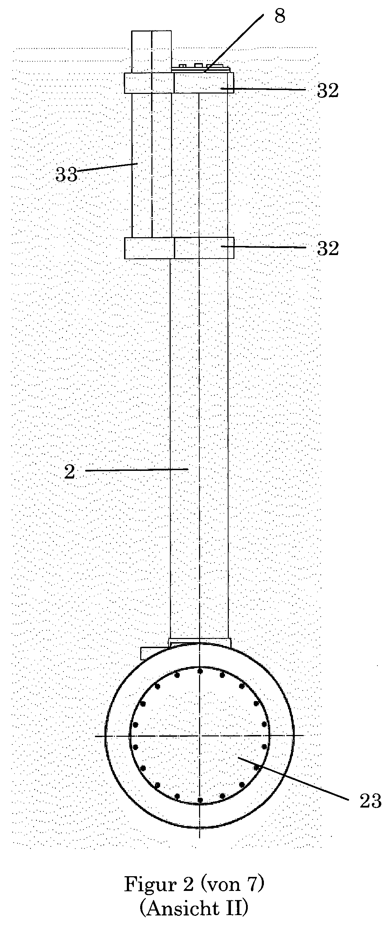

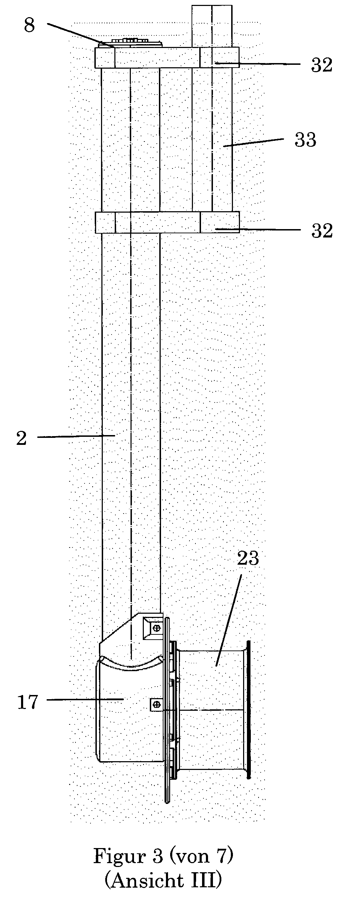

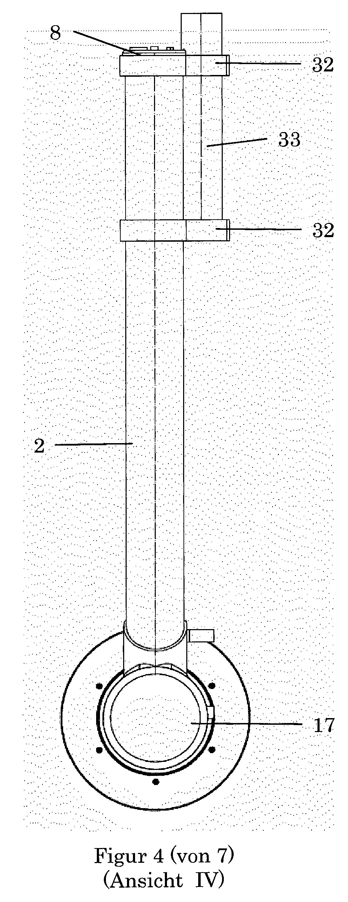

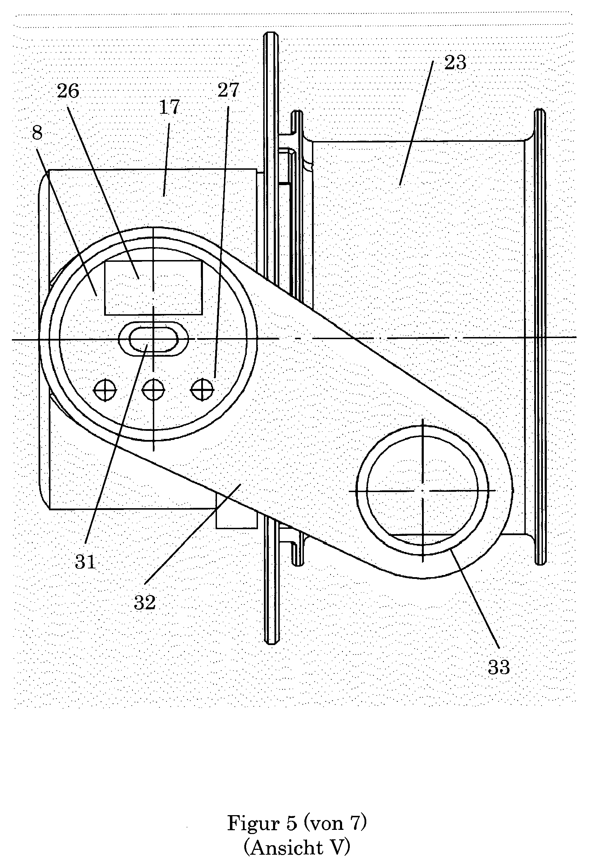

In dem Fall, dass die Einarmstütze 1 zur Anbindung eines Vorderrads an den Rahmen des Elektrofahrrads verwendet wird, wie dies in den Figuren 1 bis 7 dargestellt ist, kann das Rohr 2 über zwei Arme 32, insbesondere Fräs-, Schmiede- oder Gußteile, mit einem Lenkerrohr 33 des Elektrofahrrads fest verbunden sein. Es ist auch denkbar, die Arme 32 in Form von Parallelogrammlenkern auszuführen und weiterhin eine entsprechende Feder vorzusehen, so dass eine Vorderraddämpfung geschaffen wird. Gemäß dem Ausführungsbeispiel erstrecken sich das Rohr 2 und das Lenkerrohr 33 parallel zueinander, wobei jedoch auch nicht parallele Anordnungen denkbar sind.

Obwohl die Erfindung anhand bevorzugter Ausführungsbeispiele vorliegend beschrieben wurde, ist sie vielfältig modifizierbar.

Beispielsweise kann die Einarmstütze 1 auch im Bereich des Hinterrads des Elektrofahrrads eingesetzt werden, so dass sie dort als Einarmschwinge fungiert.

### BEZUGSZEICHENLISTE

- 1: Einarmstütze
- 2: Rohr
- 3: Energiespeicher
- 4: Längsachse
- 5: Ende
- 6: Rohr
- 7: Energiespeicherzelle
- 8: Deckel
- 9: Ende
- 11: Rand
- 12: Stopfen
- 13: Buchse
- 14: Stecker
- 15: Boden
- 16: Elektromotor
- 17: Aufnahme
- 18: Welle
- 21: Steuereinrichtung
- 22: Freilauf
- 23: Nabe
- 24: Lager
- 25: Kunststoffring
- 26: Anzeigeeinrichtung
- 27: Bedienelement
- 28: Elektronik
- 31: Stecker
- 32: Arm
- 33: Lenkerrohr
- 34: Fahrradrahmen
- 40: Elektrofahrrad

## Patentansprüche

1. Einarmstütze (1) für ein Elektrofahrrad (40) zur Anbindung eines Vorderrads des Elektrofahrrads (40) an einen Rahmen (34) desselben, mit einem Rohr (2), in welchem ein Energiespeicher (3), aus dem ein Elektromotor (16) des Elektrofahrrads (40) mit Energie zum Erzeugen von Antriebskraft versorgbar ist, aufgenommen ist, **dadurch gekennzeichnet, dass** der Energiespeicher (3) in Längsrichtung (4) des Rohrs (2) in dieses von oben einführbar ist, wobei das Rohr (2) an seinem einen Ende (5) offen zum Einführen und Entnehmen des Energiespeichers (3) für ein Austauschen desselben ausgebildet ist, und an seinem anderen Ende (9) mit einer Aufnahme (17) verbunden ist, in welcher ein Elektromotor (16) zum Antreiben des Vorderrads aufgenommen ist.

2. Einarmstütze nach Anspruch 1, wobei das eine Ende (5) des Rohrs (2) mittels eines Deckels (8), welcher Bestandteil des Energiespeichers (3) ist, verschließbar ist.

3. Einarmstütze nach Anspruch 2, wobei der Deckel (8) eine Anzeigeeinheit (26) zur Anzeige einer Energiespeicherinformation und/oder ein Bedienelement (27) zum Bereitstellen einer Bedieninformation an eine Steuereinrichtung (21, 28), welche den Energiespeicher (3) und/oder eine von einem Elektromotor (16) zu erzeugende Leistung steuert, aufweist.

4. Einarmstütze nach einem der Ansprüche 1 bis 3, wobei das Rohr (2) mit einem Lenkerrohr (33) verbunden ist.

5. Einarmstütze nach einem der Ansprüche 1 bis 4, wobei das Rohr (2) einen kreisförmigen oder ovalen Querschnitt aufweist.

6. Einarmstütze nach Anspruch 1, wobei das Vorderrad mit einer Welle (18) des Elektromotors (16) in zumindest einer Drehrichtung fest verbindbar ist.

7. Elektrofahrrad (40) mit einem Rahmen (34), einem Vorder- und Hinterrad und einer Einarmstütze (1) nach einem der Ansprüche 1 bis 6, welche das Vorderrad an den Rahmen (34) anbindet.

## Claims

1. Single-arm support (1) for an electric bicycle (40) for connecting a front wheel of the electric bicycle (40) to a frame (34) thereof, the single-arm support (1) comprising a pipe (2) including an energy storage (3) for suppling an electric motor (16) of the electric bicycle (40) with energy for generating a driving force, **characterized in that** the energy storage (3) is insertable from above into the pipe (2) in the pipe's longitudinal direction (4), wherein the pipe (2) is designed open at its one end (5) for inserting and removing the energy storage (3) for replacing the same, and is connected at its other end (9) to a receptacle (17) in which an electric motor (16) for driving the front wheel is received.

2. Single-arm support according to claim 1, wherein the one end (5) of the pipe (2) is closeable by means of a cap (8) which is part of the energy storage (3).

3. Single-arm support according to claim 2, wherein the cap (8) has a display unit (26) for displaying an energy storage information and/or a control element (27) to provide a control information to a control device (21, 28) controlling the energy storage (3) and/or a motor power to be produced by the electric motor (16).

4. Single-arm support according to any of claims 1 to 3, wherein the pipe (2) is connected to a steering shaft (33).

5. Single-arm support according to any of claims 1 to 4, wherein the pipe (2) has a circular or oval cross section.

6. Single-arm support according to claim 1, wherein the front wheel is fixedly connectable in at least one direction of rotation to a shaft (18) of the electric motor (16).

7. Electric bicycle (40) comprising a frame (34), a front wheel and a rear wheel, and a single-arm support (1) according to any of claims 1 to 6 connecting the front wheel to the frame (34).

## Revendications

1. Support à branche unique (1) pour une bicyclette électrique (40) destiné à raccorder une roue avant de la bicyclette électrique (40) à un cadre (34) de cette dernière, comportant un tube (2) dans lequel un accumulateur d'énergie (3) est logé, à partir duquel un moteur électrique (16) de la bicyclette électrique (40) peut être alimenté en énergie pour produire une force d'entraînement, **caractérisé en ce que** l'accumulateur d'énergie (3) peut être introduit dans le tube (2) par le haut dans le sens longitudinal (4) de ce dernier, le tube (2) étant réalisé ouvert au niveau d'une de ses extrémités (5) pour introduire et retirer l'accumulateur d'énergie (3) pour le remplacer, et étant relié au niveau de son autre extrémité (9) à un logement (17) dans lequel un moteur électrique (16) pour entraîner la roue avant est logé.

2. Support à branche unique selon la revendication 1, dans lequel ladite une extrémité (5) du tube (2) peut être refermée au moyen d'un couvercle (8) qui est une partie intégrante de l'accumulateur d'énergie (3).

3. Support à branche unique selon la revendication 2, dans lequel le couvercle (8) présente une unité d'affichage (26) pour afficher une information sur l'accumulation d'énergie et/ou un élément de commande (27) pour fournir une information de commande à un moyen de commande (21, 28) qui commande l'accumulateur d'énergie (3) et/ou une puissance à produire par un moteur électrique (16).

4. Support à branche unique selon l'une des revendications 1 à 3, dans lequel le tube (2) est relié à un tube de guidon (33).

5. Support à branche unique selon l'une des revendications 1 à 4, dans lequel le tube (2) présente une section circulaire ou ovale.

6. Support à branche unique selon la revendication 1, dans lequel la roue avant peut être reliée solidaire avec un arbre (18) du moteur électrique (16) dans au moins un sens de rotation.

7. Bicyclette électrique (40) comprenant un cadre (34), une roue avant et une roue arrière et un support à branche unique (1) selon l'une des revendications 1 à 6, qui raccorde la roue avant au cadre (34).
